# EUROPEAN PATENT APPLICATION

(11) **EP 3 185 665 A1**
(43) Date of publication of application: **28.06.2017**
(21) Application number: 16204069.5
(22) Date of filing: 14.12.2016
(51) Int. Cl.: H05K 9/00, H05K 7/20

(54) **ELECTRONIC CIRCUIT BOARD SHIELDING WITH OPEN WINDOW HEAT TRANSFER PATH**

(30) Priority: 22.12.2015 US 201514978682
(71) Applicant: Thomson Licensing, 92130 Issy-les-Moulineaux (FR)
(72) Inventor: HUNT, Mickey Jay, Camby, IN Indiana 46113 (US); CARPENTER, Joseph Lee, Noblesville, IN Indiana 46060 (US); RITTER, Darin Bradley, Indianapolis, IN Indiana 46240 (US)
(74) Representative: Huchet, Anne

(57) **Abstract**

An improved heat transfer system for components an electronic device is provided. The electronic device includes a printed circuit board, a component shield and a heatsink or heat spreader. An open heat transfer window is positioned in the component shield so as to enable the heat sink to directly contact a thermal pad for a component requiring heat dissipation. Grounding fingers between the shield and the heatsink may be provided to connect the shield to the heatsink, thereby protecting the component against electromagnetic interference and electrostatic discharge from the outside while preventing the component from leaking radio frequency radiation to the outside resulting from the creation of the open heat transfer window in the shield.

## Description

### BACKGROUND

### 1. Field of Technology

The present principles relate to electronic devices with circuit boards having one or more components requiring heat dissipation. More particularly, it relates to a printed circuit board shield design for increasing component heat transfer/ dissipation away from the components requiring the same.

### 2. Discussion of Related Art

Thermal management remains a significant challenge in electronic devices such as, for example, set top boxes and network gateways. With the introduction of more components having increased processing capabilities and increased functionalities, which tend to produce more heat, the need for an improved thermal management system exists.

An additional complication in the trend of electronic devices is the need to reduce the size of the device due to consumer preference. This trend for compactness also makes thermal management a challenge, because greater compactness with an increased number of internal components generally results in a higher concentration of heat.

Proper thermal contact between a thermal pad on a circuit board component and a heatsink improves heat dissipation from the circuit board. Additionally, heat spreaders (i.e., heatsinks) with associated shields (e.g., Radio Frequency or Ground shields) are often used to contain or prevent frequency interference generated by the electronic components on the circuit board, and can also operate to improve heat dissipation from one or more electronic components. However, those of skill in the art will appreciate that existing structure and techniques for securing a shield with an associated heatsink against the thermal pad of a particular component results in an insufficient grounding of the heatsink within the electronic device.

Therefore, a need exists to provide sufficient grounding of the heatsink to the printed circuit board through the component shield without negatively impacting the required heat dissipation of one or more components contained within the confines of the shield.

### SUMMARY

Embodiments of the disclosure provide an electronic device having a printed circuit board having one or more electronic components requiring heat dissipation. The electronic device includes a shield configured to be positioned on at least a part of the printed circuit board and having one or more open heat transfer windows positioned over the one or more electronic components requiring heat dissipation. The heatsink has one or more surfaces configured to be positioned over the one or more open heat transfer windows in the shield.

According to a particular embodiment, the electronic device further has one or more thermal pads that have one side positioned directly on the one or more components requiring heat dissipation. The one or more surfaces of the heatsink physically contacting an opposing side of the one or more thermal pads through the one or more open heat transfer windows in the shield.

According to a particular embodiment of the electronic device the shield comprises one or more fingers positioned around the one or more open heat transfer windows, the one or more fingers being configured to make a physical and electrical connection with the heatsink to the shield when said one or more surfaces of said heatsink are positioned over the one or more open heat transfer windows in the shield.

According to a particular embodiment of the electronic device the one or more fingers comprise one or more fingers positioned around a periphery of the one or more open heat transfer windows in the shield.

According to a particular embodiment of the electronic device the one or more fingers are upwardly biased with respect to a planar surface of the shield to ensure electrical contact with the one or more surfaces of the heatsink.

According to a particular embodiment of the electronic device there is further comprised a spacing between the one or more fingers, the spacing being based on radio frequency wavelengths to be blocked by the shield.

According to a particular embodiment of the electronic device the spacing is at least one tenth of a maximum of the radio frequency wavelengths to be blocked by the shield.

According to a particular embodiment of the electronic device the one or more surfaces are configured to present one or more depressions in the heatsink.

According to a particular embodiment of the electronic device the one or more surfaces are configured to be co-planar with the heatsink.

According to a particular embodiment of the electronic device the one or more surfaces are configured to protrude from the heatsink.

### BRIEF DESCRIPTION OF THE DRAWINGS

A more detailed understanding of the invention may be obtained from the following description, in conjunction with the accompanying drawings, wherein:
FIG. 1 is an exploded view of an electronic device according to the prior art;
FIG. 2 is a partially assembled view of the electronic device of Figure 1, according to the prior art;
FIG. 3 is an enlarged partial cross section of the component to heatsink connection for the prior art electronic device of FIGS. 1 and 2;
FIGs. 4a and 4b are exploded views of an electronic device according to implementations of the present principles;
FIG. 5 is a partially assembled view of the electronic device of Figures 4a and 4b, according to an implementation of the present princples;
FIG. 6 is an enlarged view of the open window of the component shield of the electronic device, according to an implementation of the present principles;
FIG. 7A shows an enlarged side view of the open heat transfer window in the component shield of the fully assembled electronic device according to an implementation of the present principles; and
FIG. 7B shows an enlarged side view of the open heat transfer window in the component shield of the fully assembled electronic device according to a different implementation of the present principles.

### DETAILED DESCRIPTION

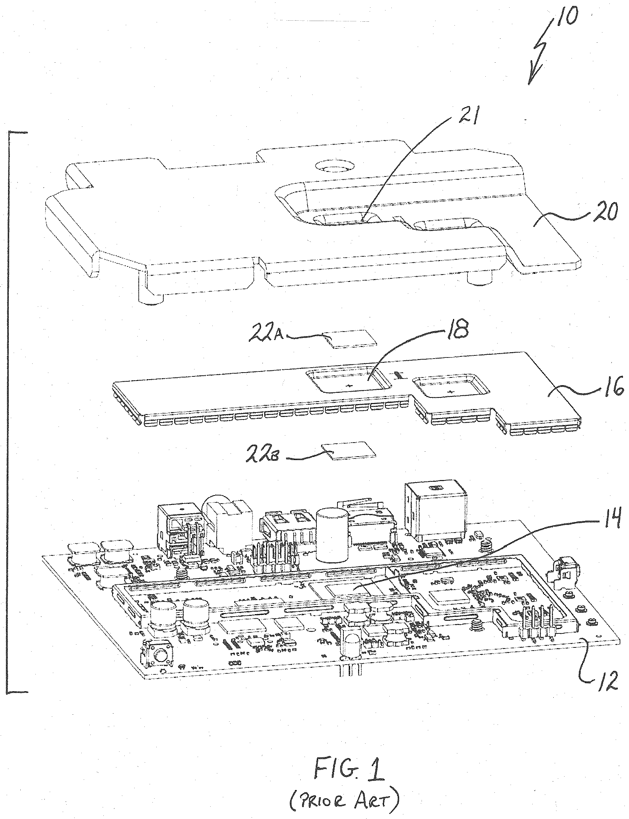

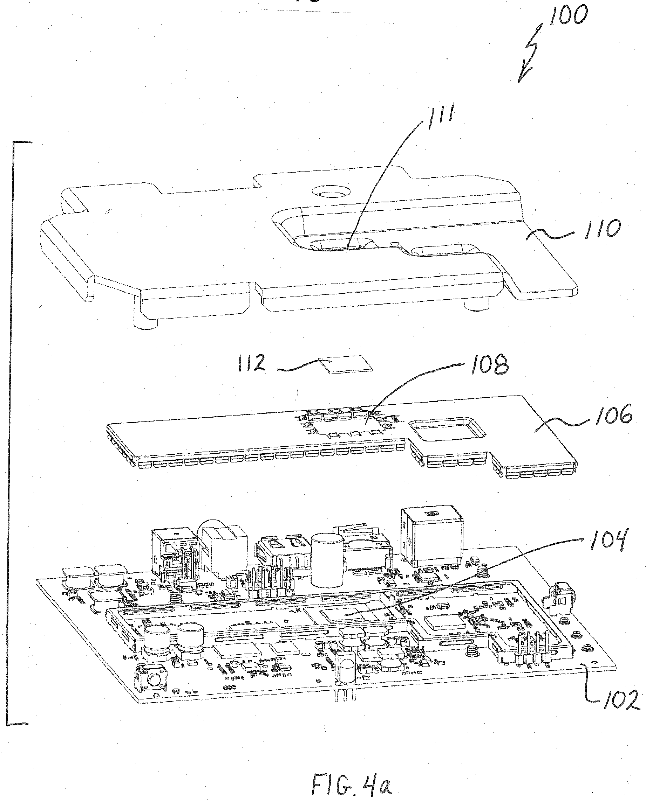

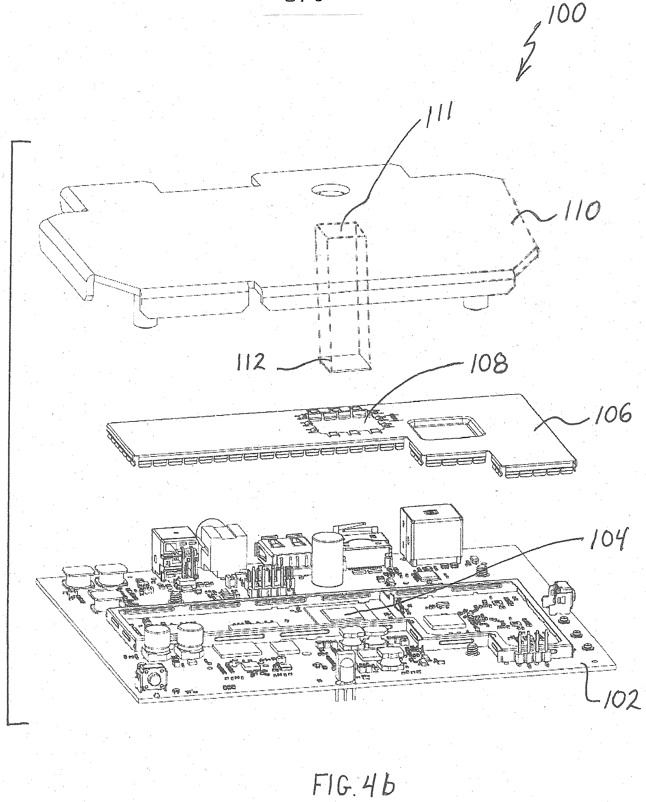

As illustrated in FIG. 1, an electronic device 10 of the prior art is made up of a printed circuit board (PCB) 12, a shield 16 and heatsink or heat spreader 20. The PCB 12 includes many components, some of which generate more heat than others and which require heatsinks to aid in the dissipation of that heat during operation. One example of such components is identified as reference 104 in FIGs. 4a and 4b.

Generally speaking, those of skill in the art will appreciate that the shield 16 is configured to shield part of the PCB components from the other components on the PCB for various reasons, but primarily to shield radio frequency interference from either radiating to surrounding components from components contained within the shield, or generated by components outside the shield from affecting those components within the shield. This radio frequency interference (RFI) is also commonly referred to as electromagnetic interference or EMI.

According to one implementation, the electronic device of the present principles would be a set top box generally provided to customers through respective content providers. In other implementations, the electronic device of the present principles can be a gateway device used to assist in the transmission of content to or from a customer or content source provider, respectively. Those of skill in the art will appreciate that other implementations of the present principles into many different types of electronic devices can be made without departing from the intended scope of the same.

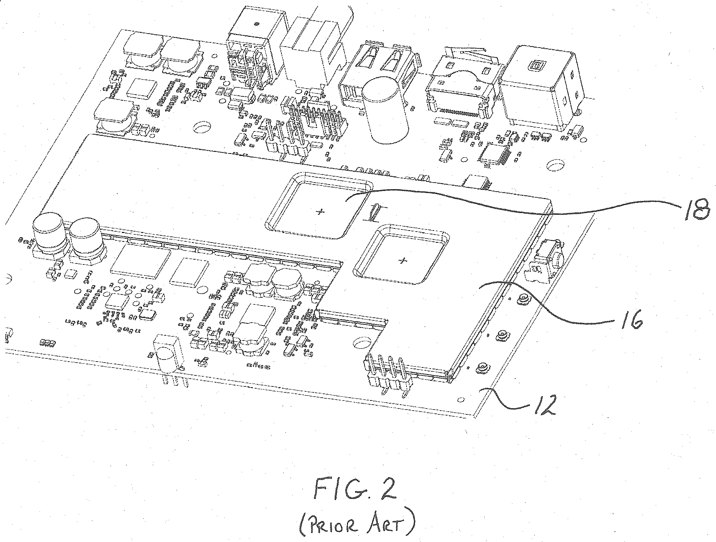

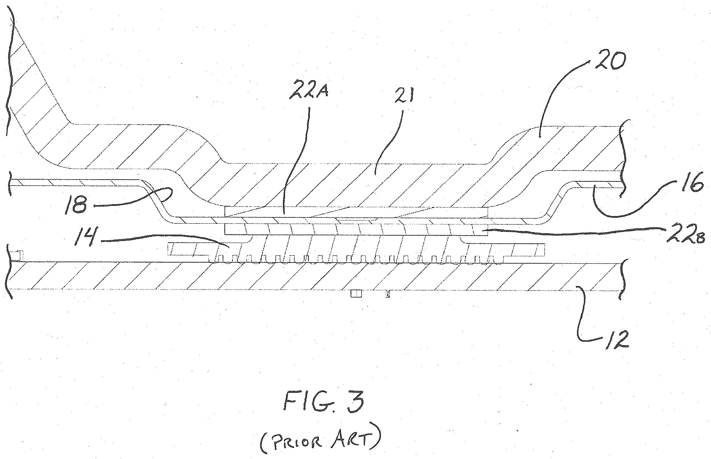

Referring to FIGS. 1-3, the shield 16 includes one or more embossments 18 which are positioned over the components 14 requiring heat dissipation. Thermo (thermal, thermally conductive) pads 22A, 22B are used to transfer the heat from component 14 to the heatsink 20. As shown in FIG. 3, the underside of thermo pad 22B is positioned directly on the component 14. The upper side of thermo pad 22B is in direct thermal contact with the embossment 18 of the shield 16, and an upper thermo pad 22A is in direct contact with the embossment 18 on its bottom side and the depression 21 in the heatsink 20 on the upper side. (See FIG. 3). In this manner, heat generated by component 14 is transferred via thermo pad 22B, embossment 18, and thermo pad 22A to the heatsink or heat spreader 20. Although this known design is effective for heat transfer from the components, a significant problem arises in the proper grounding of the heatsink 20 with respect to the PCB. Such grounding problems can interfere in many aspects of the operation of the electronic device, not the least of which is damage to one or more of the electronic components on the PCB, ultimately resulting in failed operation of the electronic device 10. One of those problems is caused by what is commonly referred to as ESD or Electrostatic discharge.

Referring to FIGs. 4a and 4b, there is shown an electronic device 100 according to an implementation of the present principles. The electronic device 100 is made up of a printed circuit board (PCB) 102, a shield 106 and heatsink or heat spreader 110. In this implementation, the shield 106 includes an open window 108 (hereinafter referred to as the "heat transfer window") where a thermo-coupling between a component 104 and heatsink 110 will be made. FIG. 4a shows an implementation wherein surface 111 that is in contact with thermo pad 112 is a depression in heatsink 110. Fig. 4b shows an implementation wherein surface 111 is co-planar (level with, in the same horizontal plane as) heatsink 110. According to a different implementation (not shown) the surface 111 protrudes from heatsink 110.

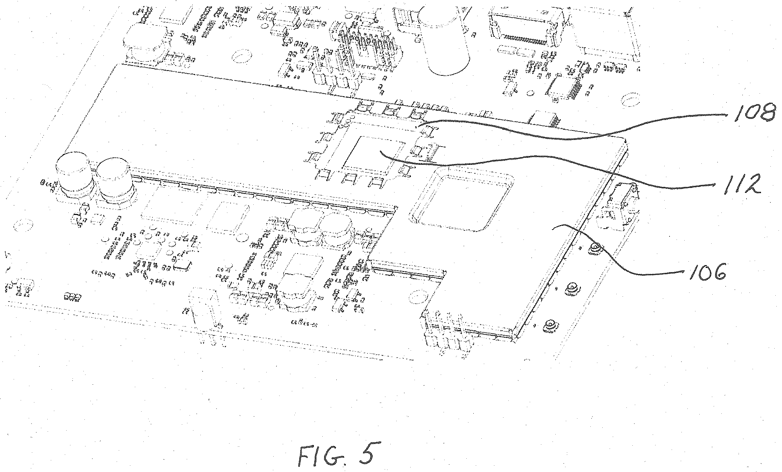

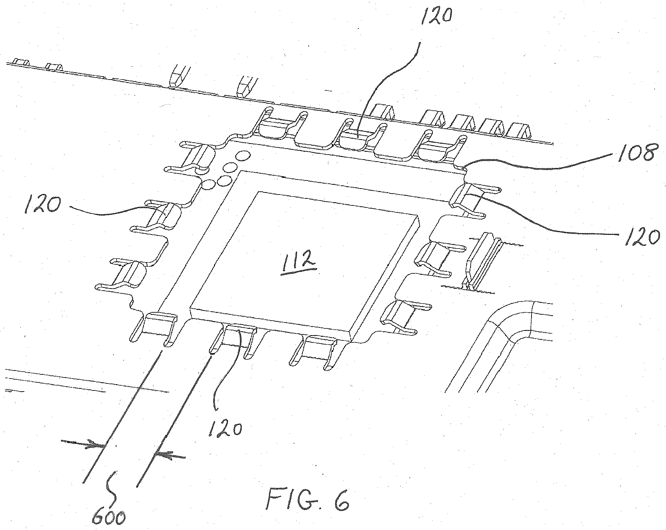

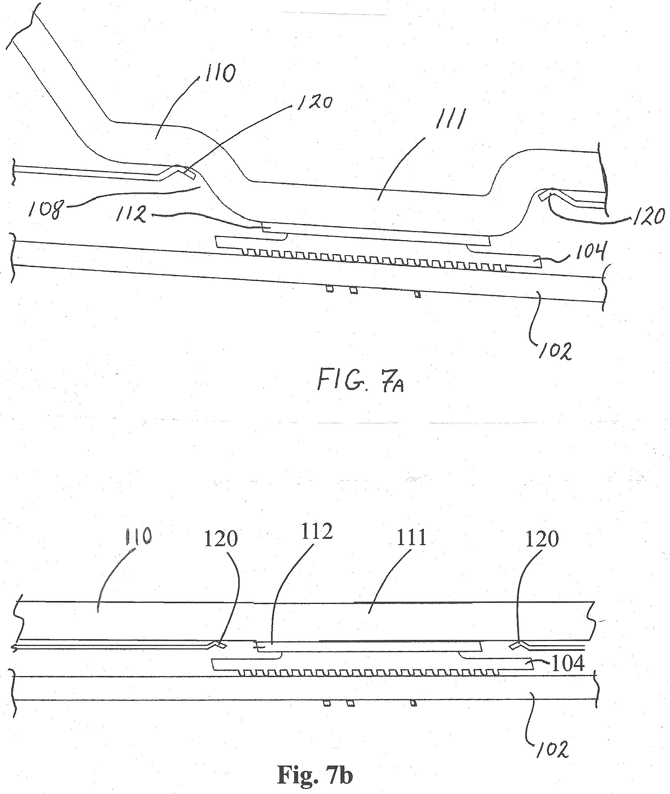

FIGS. 5 and 6 show a view of the shield 106 in its operable position on the PCB 102. As shown, the heat transfer window 108 is aligned with the component 104 (FIGS. 4 and 7) and the thermo pad 112 is positioned over the same. The shield 106 can include a plurality of ground fingers 120 positioned around the periphery of the heat transfer window 108. The ground fingers 120 are spring biased and protrude upward from the planar surface of the shield 106 and are configured to physically engage the depression 111 in the heatsink 110. The upward spring bias of the ground fingers 120 assures consistent and accurate physical and electrical contact between the shield 106 and heatsink 110, via depression 111.

FIGS. 7A and 7B show a side view of the open heat transfer window in the component shield of the assembled electronic device according to different implementations of the present principles. As shown in FIG. 7A, the surface 111 of the heatsink 110 (marked by a depression in the heatsink) is positioned over the open heat transfer window 108 and directly contacts the thermo pad 112 positioned on component 104. As shown in FIG. 7B, the surface 111 (marked by broken lines that indicate the surface on the underside of the heatsink where the thermo pad 112 is brought into contact with the heatsink) of the heatsink 110 is positioned over the open heat transfer window 108 in shield 106 and directly contacts the thermo pad 112 positioned on component 104 as the top surface of thermo pad 112 is nearly level with or slightly protrudes from (extends above) the open heat transfer window 108 in the shield 106. According to yet another implementation of the present principles (not shown), the surface 111 of the heatsink 110 that is positioned over the open heat transfer window 108 in the shield 106 protrudes from the heatsink due to thermo pad 112 protruding from the open heat transfer window 108 in shield 106. Heatsink 110 can be formed as depicted in FIG. 7A and thus comprise an embossment at the surface 111 even if the thermo pad 112 does not protrude from the shield 106. Such form of the heatsink 110 may be advantageous as it increases the distance between the heatsink 110 and the shield 106 so as to further improve the airflow around heatsink 110, thereby further improving the capacity of heatsink 110 to evacuate heat from component 104 while decreasing heat transfer of the heatsink 110 to the shield 106 and the components on the printed circuit board. Thus, it will be apparent that this thermo-coupling and thereby the thermal conductivity of the component 104 to the heatsink 110 is improved. This design provides more efficient heat transfer than that of the prior art, by eliminating one thermo pad and the shield layer (i.e., layer of sheet metal) which would otherwise be present in the thermo path to affect this thermo-coupling. Indeed, in the prior art electronic device 10 according to FIG.1, as the shield 16 is included in the thermo coupling between component 14 and heatsink 20, will be heated by component 14 and therefore radiate heat to other components on PCB 12 directly under the shield 16 and near to the outside borders of the shield 16, which is not desired and which can be detrimental to the functioning of these other components and to the functioning of the electronic device 10 in general.

Importantly, the present principle of having an open heat transfer window with ground fingers 120 around the periphery of the heat transfer window 108 physically and electronically coupling the shield 106 to the heatsink 110 avoids the shield from being included in the thermo coupling between component 104 and heatsink 110. In this manner, the aforementioned problems associated with grounding of the heatsink 110 and heat radiation of the shield to other components on the PCB are eliminated and the heatsink is now sufficiently grounded to the PCB, via the ground fingers 120 of shield 106. In addition, once assembled, any potential losses in shielding created by the window 108 are eliminated by the heatsink with surface 111 being positioned over the window 108 as the heatsink is grounded and closes the area formed by the open heat transfer window. Those of skill in the art will appreciate that the metallic, electrically conductive body of the heatsink functionally closes the open heat transfer window 108. For an implementation providing improved shielding, the ground fingers 120 are spaced close enough together to prevent gaps larger than a selected maximum wavelength of a wavelength range which can be deemed to be detrimental, thereby effectively attenuating or blocking radiation wavelengths of radiation above that spacing size from passing through the gap around the shield 106 and the open heat transfer window 108. Fig. 6 shows an example of a spacing 600 between adjacent ground fingers 120 selected so as to maintain the desired shielding effect of the shield based on the selected maximum wavelength. By way of example, a general rule can be applied where an aperture at 1/10 of a particular wavelength will attenuate or block 90% of the radiation of that wavelength incident on the aperture and attenuate more than 90% above that wavelength. Those of skill in the art will appreciate that "aperture" as used in the above example is analogous to the spacing 600 between adjacent ground fingers 120. As such, the same concepts apply to the present principles. The grounding fingers between the shield and the heatsink connect the shield to the heatsink, thereby protecting the component against electromagnetic interference and electrostatic discharge from the outside while preventing the component from leaking radio frequency radiation to the outside resulting from the creation of the open heat transfer window in the shield.

Those of skill in the art will appreciate that the physical form of ground fingers 120 may be different than that shown in the figures without departing from the intended scope of the present principles, provided such fingers are configured to consistently make a good physical and electrical connection with the corresponding heatsink/heat spreader. In one preferred implementation, the ground fingers 120 are spring biased upward such that the heatsink 110 will be forced downward against such spring bias when assembling the electronic device, thus assuring proper physical and electrical contact.

The foregoing illustrates some of the possibilities for practicing the present principles. Many other embodiments are possible within the scope and spirit of the present principles. It is, therefore, intended that the foregoing description be regarded as illustrative rather than limiting, and that the scope of the present principles is given by the appended claims together with their full range of equivalents.

## Claims

1. An electronic device having a printed circuit board (102) having one or more electronic components (104) requiring heat dissipation, the electronic device comprising:
a shield (106) configured to be positioned on at least a part of the printed circuit board and having one or more open heat transfer windows (108) positioned over the one or more electronic components requiring heat dissipation; and
a heatsink (110) having one or more surfaces (111) configured to be positioned over the one or more open heat transfer windows in the shield.

2. The electronic device of claim 1, further comprising one or more thermal pads (112) having one side positioned directly on the one or more components requiring heat dissipation, said one or more surfaces of said heatsink physically contacting an opposing side of said one or more thermal pads through said one or more open heat transfer windows in the shield.

3. The electronic device of claim 1 or 2, wherein the shield comprises one or more fingers (120) positioned around the one or more open heat transfer windows, said one or more fingers being configured to make a physical and electrical connection with the heatsink to the shield when said one or more surfaces of said heatsink are positioned over said one or more open heat transfer windows in said shield.

4. The electronic device of claim 3, wherein said one or more fingers comprise one or more fingers positioned around a periphery of the one or more open heat transfer windows in said shield.

5. The electronic device of claim 4, wherein said one or more fingers are upwardly biased with respect to a planar surface of the shield to ensure electrical contact with the one or more surfaces of the heatsink.

6. The electronic device of claim 3, further comprising a spacing (600) between said one or more fingers, said spacing being based on radio frequency wavelengths to be blocked by said shield.

7. The electronic device of claim 6, wherein said spacing is at least one tenth of a maximum of said radio frequency wavelengths to be blocked by said shield.

8. The electronic device according to any of claims 1 to 7, wherein said one or more surfaces are configured to present one or more depressions in said heatsink.

9. The electronic device according to any of claims 1 to 7, wherein said one or more surfaces are configured to be co-planar with said heatsink.

10. The electronic device according to any of claims 1 to 7, wherein said one or more surfaces are configured to protrude from said heatsink.
